(19)

Europäisches
Patentamt
European
Patent Office
Office européen
des brevets

(11) **EP 2 444 978 A2**

(12) **EUROPEAN PATENT APPLICATION**

(43) Date of publication:
25.04.2012 Bulletin 2012/17

(51) Int Cl.:
*H01B 1/02* (2006.01)  *H01L 31/0224* (2006.01)
*C22F 1/08* (2006.01)

(21) Application number: 11185699.3

(22) Date of filing: 19.10.2011

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: 20.10.2010 JP 2010235271

(71) Applicant: **Hitachi Cable, Ltd.**
**Chiyoda-ku**
**Tokyo (JP)**

(72) Inventors:
• **Sagawa, Hideyuki**
  **Tokyo (JP)**
• **Sumi, Toru**
  **Tokyo (JP)**

• **Kuroda, Hiromitsu**
  **Tokyo (JP)**
• **Aoyama, Seigi**
  **Tokyo (JP)**
• **Shirato, Masao**
  **Tokyo (JP)**
• **Kimoto, Kuniaki**
  **Tokyo (JP)**
• **Sawahata, Katsunori**
  **Tokyo (JP)**
• **Higashidani, Iku**
  **Tokyo (JP)**

(74) Representative: **Betten & Resch**
**Patentanwälte**
**Theatinerstrasse 8**
**80333 München (DE)**

(54) **Solar cell conductor and method of manufacturing the same**

(57)    A solar cell conductor includes an additive element including at least one of Mg, Zr, Nb, Ca, V, Ni, Mn, Ti and Cr, more than **2** mass ppm of oxygen, pure copper including an inevitable impurity, a **0.2**% proof stress value of not more than **55** MPa, and an elongation percentage of not less than **25**%. A method of manufacturing a solar cell conductor includes making a molten metal by melting a dilute copper alloy material at a copper melting temperature of not less than **1100**˚C and not more than **1320**˚C, the dilute copper alloy material including more than **2** mass ppm of oxygen and an additive element, forming a wire rod from the molten metal, hot-rolling the wire rod at a temperature of not more than **880**˚C and not less than **550**˚C, and forming a conductor by drawing the hot-rolled wire rod.

FIG.16

EP 2 444 978 A2

**Description**

BACKGROUND OF THE INVENTION

**1.** FIELD OF THE INVENTION

The invention relates to a solar cell conductor and a method of manufacturing the solar cell conductor.

**2.** DESCRIPTION OF THE RELATED ART

As a conventional technique, a solder-plated wire for a solar cell is known in which a surface of a conductor formed in a flat rectangular shape is partially or entirely coated with solder plating, a **0.2**% proof stress value of the conductor in a tensile test is not more than **90** MPa and a crystal grain size of the conductor is not less than **20** $\mu$m and not more than **300** $\mu$m (see WO2005/114751).

The solder-plated wire for a solar cell is less likely to cause breakage of a solar battery cell due to a heating process during solder bonding of the conductor or due to temperature variation during use of a solar cell, and is very effective against the problem of crack generation in the conductor.

SUMMARY OF THE INVENTION

In the meantime, considering further cost reduction of a solar cell, tendency of further thinning a solar battery cell which currently has a thickness of **300** $\mu$m and rises cost will become remarkable and the problem of breakage of a solar battery cell will be exposed. A currently developed solar cell conductor has low proof stress of about **60** MPa in a state of being coated with solder, and lower proof stress is demanded in accordance with thinning of the solar battery cell. On the other hand, although the solar cell conductor having an enhanced low proof stress is required to be heat-treated under the conditions of high temperature and long term, there is a problem that crystal grain coarsening is enhanced, innovation of conductor progresses and bending fatigue characteristics are inferior.

Therefore, it is an object of the invention to provide a solar cell conductor that suppresses breakage of a solar battery cell and is excellent in bending fatigue characteristics, and a method of manufacturing the solar cell conductor.

(**1**) According to one embodiment of the invention, a solar cell conductor comprises:

an additive element including at least one of Mg, Zr, Nb, Ca, V, Ni, Mn, Ti and Cr;
more than **2** mass ppm of oxygen;
pure copper comprising an inevitable impurity;
a **0.2**% proof stress value of not more than **55** MPa; and
an elongation percentage of not less than **25**%.

In the above embodiment (**1**) of the invention, the following modifications and changes can be made.

(i) The additive element comprises **4** to **25** mass ppm of Ti, and **3** to **12** mass ppm of sulfur.

(**2**) According to another embodiment of the invention, a method of manufacturing a solar cell conductor comprises:

making a molten metal by melting a dilute copper alloy material at a copper melting temperature of not less than **1100**°C and not more than **1320**°C, the dilute copper alloy material comprising more than **2** mass ppm of oxygen and an additive element;
forming a wire rod from the molten metal;
hot-rolling the wire rod at a temperature of not more than **880**°C and not less than **550**°C; and
forming a conductor by drawing the hot-rolled wire rod.

In the above embodiment (**2**) of the invention, the following modifications and changes can be made.

(ii) The additive element comprises at least one of Mg, Zr, Nb, Ca, V, Ni, Mn, Ti and Cr.

(iii) The additive element comprises **4** to **25** mass ppm of Ti and **3** to **12** mass ppm of sulfur.

Effects of the invention

According to one embodiment of the invention, a solar cell conductor can be provided that suppresses breakage of a solar battery cell and is excellent in bending fatigue characteristics, as well as a method of manufacturing the solar cell conductor.

BRIEF DESCRIPTION OF THE DRAWINGS

Next, the present invention will be explained in more detail in conjunction with appended drawings, wherein:

**FIG.1** is an SEM image showing TiS particle;
**FIG.2** is a graph showing a result of analysis of **FIG.1**;
**FIG.3** is an SEM image showing $TiO_2$ particle;
**FIG.4** is a graph showing a result of analysis of **FIG.3**;
**FIG.5** is an SEM image showing Ti-O-S particle;
**FIG.6** is a graph showing a result of analysis of **FIG.5**;
**FIG.7** is a schematic view showing a bending fatigue test;
**FIG.8** is a graph showing bending lives of Comparative Material **13** using an oxygen-free copper wire and Example Material 7 using a soft dilute copper alloy wire in which Ti is added to low-oxygen copper, which are measured after annealing treatment at **400**˚C for **1** hour;
**FIG.9** is a graph showing bending lives of Comparative Material **14** using an oxygen-free copper wire and Example Material **8** using a soft dilute copper alloy wire in which Ti is added to low-oxygen copper, which are measured after annealing treatment at **600**˚C for **1** hour;
**FIG.10** is a photograph showing a cross section structure across-the-width of Example Material **8**;
**FIG.11** is a photograph showing a cross section structure across-the-width of a sample of Comparative Material **14**;
**FIG.12** is an explanatory diagram illustrating a method of measuring an average crystal grain size in a surface layer of a sample;
**FIG.13** is a schematic view showing a solar cell module using a solar cell conductor in Example **2**;
**FIG.14** is a photograph showing a cross section structure across-the-width of Example Material 9;
**FIG.15** is a photograph showing a cross section structure across-the-width of a sample of Comparative Material **15**; and
**FIG.16** is a graph showing a relation between an annealing temperature (˚C, **1** hour) and elongation (%).

DETAILED DESCRIPTION OF THE PREFERRED EMBODIMENTS

Outline of Manufacturing method of Solar cell conductor

The outline of a manufacturing method of a solar cell conductor in the present embodiment is as follows. Firstly, a dilute copper alloy material including more than **2** mass ppm of oxygen as well as an additive element is prepared (a raw material preparing step). Next, a molten metal is made from the dilute copper alloy material at a casting temperature of not less than **1100**˚C and not more than **1320**˚C (a molten metal manufacturing step). Then, a wire rode is made from the molten metal (a wire rod making step). Following this, the wire rod is hot-rolled at a temperature of not more than **880**˚C and not less than **550**˚C (a hot-rolling step). Then, a conductor is manufactured by drawing the hot-rolled wire rod (a conductor manufacturing step). As a result, a conductor having a **0.2**% proof stress value of not more than **55** MPa and an elongation percentage of not less than **25**% is manufactured as a solar cell conductor in the present embodiment.

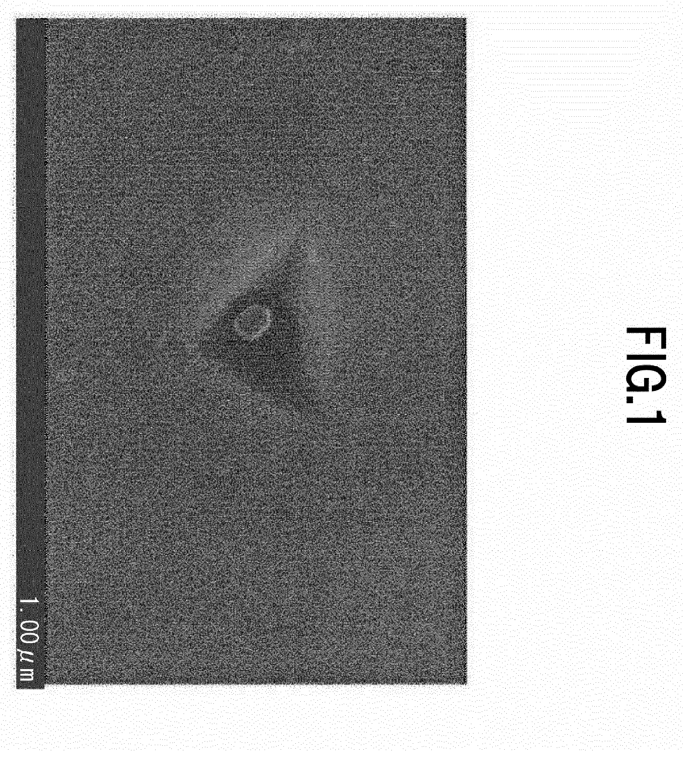

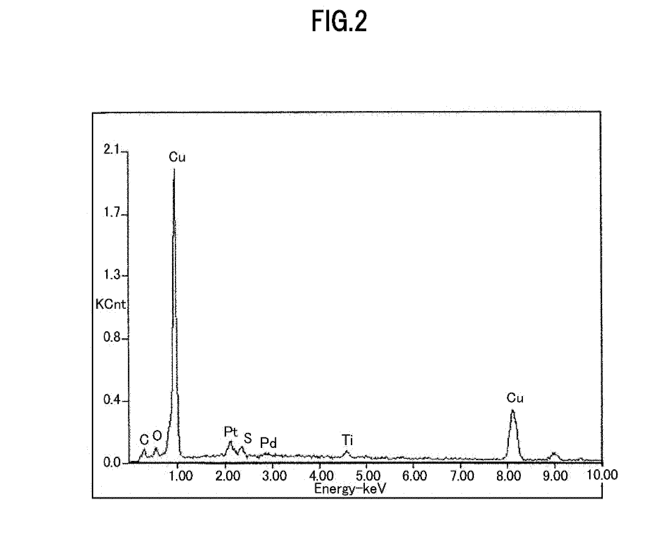

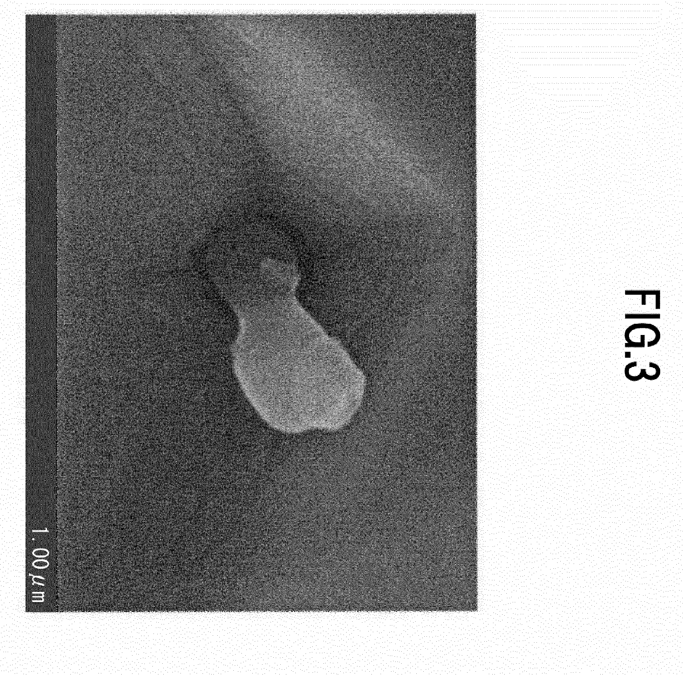

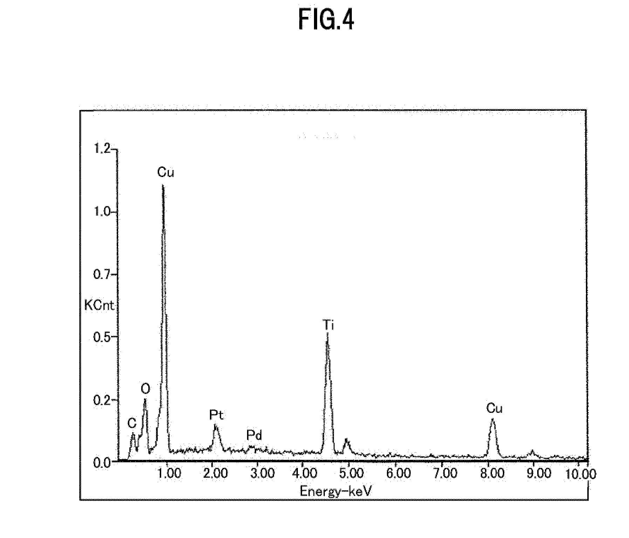

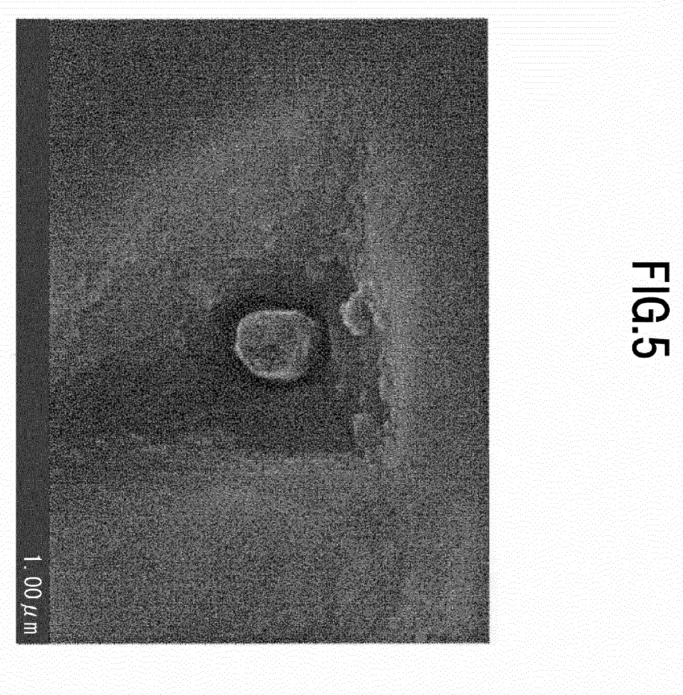

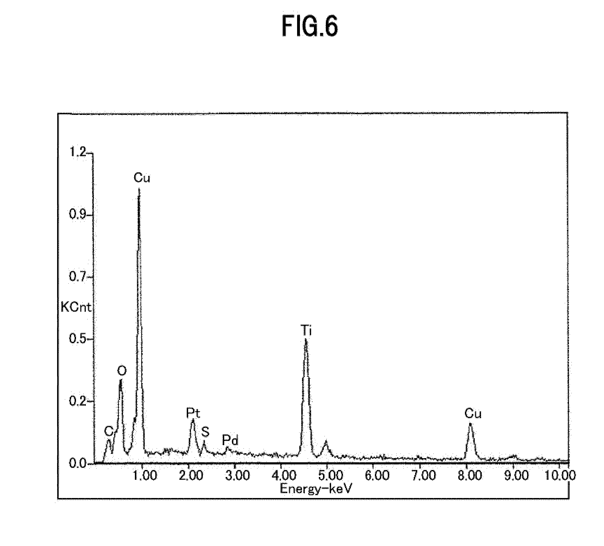

A preferred embodiment of the invention will be described in detail below. **FIG.1** is an SEM image showing TiS particle. **FIG.2** is a graph showing a result of analysis of **FIG.1**. **FIG.3** is an SEM image showing $TiO_2$ particle. **FIG.4** is a graph showing a result of analysis of **FIG.3**. **FIG.5** is an SEM image showing Ti-O-S particle. **FIG.6** is a graph showing a result of analysis of **FIG.5**.

To begin with, a solar cell conductor in the present embodiment is formed using a soft dilute copper alloy material as a soft copper material which satisfies a conductivity of **98**% IACS (International Annealed Copper Standard, conductivity is defined as **100**% when resistivity is **1.7241** x $10^{-8}$ Ωm), **100**% IACS, or further, **102**% IACS. Since a SCR continuous casting equipment is used, there are few surface flaws, a manufacturing range is wide and stable manufacturing is possible. In addition, this is to develop a material having a softening temperature of not more than **148**˚C when a working ratio of a wire rod is **90**% (e.g., processing from a **8** mm diameter wire into a **2.6** mm diameter wire).

The points studied by the inventors to realize a solar cell conductor in the present embodiment will be explained below. The softening temperature at the working ratio of **90**% is **130**˚C for high purity copper (**6**N, a purity of **99.9999**%).

Therefore, the inventors sought a raw material as a soft dilute copper alloy material which allows stable manufacturing of soft copper having a softening temperature of not less than **130**°C and not more than **148**°C as a temperature allowing stable manufacturing and a conductivity of not less than **98**% IACS, not less than **100**% IACS, or further, not less than **102**% IACS, and the manufacturing conditions thereof.

Here, a **8** mm diameter wire rod is manufactured from molten metal using high purity copper (**4**N) with an oxygen concentration of **1** to **2** mass ppm and having several mass ppm of titanium added thereto by a small continuous casting machine in an experimental laboratory, and then is drawn to have a **2.6** mm diameter (at a working ratio of **90**%). The measured softening temperature is **160** to **168**°C and cannot be lower than this temperature. In addition, the conductivity is about **101.7**% IACS. Therefore, it was found that, even though the oxygen concentration is reduced and titanium is added, it is not possible to lower the softening temperature and the conductivity is inferior to that of high purity copper (**6**N) which is **102.8**% IACS.

It is presumed that the softening temperature is not lowered because several mass ppm or more of sulfur is mixed as an inevitable impurity during manufacturing of the molten metal and sulfide such as TiS, etc., is not sufficiently formed by sulfur and titanium.

Accordingly, two measures were examined in the present embodiment in order to lower the softening temperature and to improve the conductivity, and a combination of two effects thereof achieved the subject.

(a) The oxygen concentration of the raw material is increased to more than **2** mass ppm, and then, titanium is added thereto. It is considered that the TiS, titanium oxide ($TiO_2$) or Ti-O-S particle is initially formed in molten copper (see the SEM images of **FIGS.1** and **3** and the results of analysis of **FIGS.2** and **4**). It should be noted that platinum (Pt) and platinum (Pd) in of **FIGS.2**, **4** and **6** are vapor deposition elements used for the purpose of observation.

(b) Next, the hot rolling temperature is set to be lower (**880** to **550**°C) than the temperature under the typical manufacturing conditions of copper (**950** to **600**°C) so that dislocation is introduced into copper for easy precipitation of S. As a result, S is precipitated on the dislocation or is precipitated using titanium oxide ($TiO_2$) as a nucleus, and for example, Ti-O-S particle, etc., is formed in the molten copper (see the SEM image of **FIG.5** and the result of analysis of **FIG.6**). In **FIGS.1** to **6**, a cross section of a **8** mm diameter copper wire (wire rod) having an oxygen concentration, a Ti concentration and a sulfur concentration which are shown in the third row of Example Material **1** in Table **1** is evaluated by an SEM observation and an EDX analysis. The observation conditions are an acceleration voltage of **15** keV and an emission current of **10** μA.

The sulfur in the copper is crystallized and precipitated by the above (a) and (b), and then, a copper wire rod having satisfactory softening temperature and conductivity is formed after a cold wire drawing process.

Next, the invention limits the following (**1**) to (**4**) as a limitation of the manufacturing conditions when using the SCR continuous casting equipment.

(**1**) Composition

A solar cell conductor in the present embodiment contains an additive element including at least one of Mg, Zr, Nb, Ca, V, Ni, Mn, Ti and Cr, more than **2** mass ppm of oxygen and pure copper with inevitable impurities, and has a **0.2**% proof stress value of not more than **55** MPa and an elongation percentage of not less than **25**%. Here, the reason why element(s) selected from the group consisting of Mg, Zr, Nb, Ca, V, Ni, Mn, Ti and Cr is selected as an additive element is that these elements are active elements which are likely to bind to other elements and thus likely to bind to S, which allows S to be trapped and a copper base material (matrix) to be highly purified. One or more additive elements should be contained. Alternatively, other elements or impurities which do not adversely affect the properties of an alloy may be contained in the alloy.

In addition, although it is explained in the preferred embodiment below that the favorable oxygen content is more than **2** but not more than **30** mass ppm, oxygen can be included in an amount of more than **2** but not more than **400** mass ppm within a range providing the properties of the alloy, depending on the added amount of the additive element and the S content.

In order to obtain a soft copper material having a conductivity of not less than **98**% IACS, a soft dilute copper alloy material in which pure copper with inevitable impurities (a base material) includes **3** to **12** mass ppm of sulfur, more than **2** but not more than **30** mass ppm of oxygen and **4** to **55** mass ppm of Ti is used to manufacture a wire rod (a roughly drawn wire). The object used in the present embodiment includes more than **2** but not more than **30** mass ppm of oxygen, hence, is so-called low-oxygen copper (LOC).

Here, in order to obtain a soft copper material having a conductivity of not less than **100**% IACS, a wire rod should be formed of a soft dilute copper alloy material using pure copper with inevitable impurities in which **2** to **12** mass ppm of sulfur, more than **2** but not more than **30** mass ppm of oxygen and **4** to **37** mass ppm of Ti are included.

In addition, in order to obtain a soft copper material having a conductivity of not less than **102**% IACS, a wire rod should be formed of a soft dilute copper alloy material using pure copper with inevitable impurities in which **3** to **12** mass ppm of sulfur, more than **2** but not more than **30** mass ppm of oxygen and **4** to **25** mass ppm of Ti are included.

In the industrial production of pure copper, sulfur is generally introduced into copper during the manufacturing of electrolytic copper, and it is difficult to adjust sulfur to be not more than **3** mass ppm. The upper limit of the sulfur concentration for general-purpose electrolytic copper is **12** mass ppm.

The amount of oxygen is controlled to be more than **2** mass ppm since the softening temperature is less likely to decrease when the amount of oxygen is low, as described above. On the other hand, since surface flaws are likely to be generated during the hot rolling process when the amount of oxygen is too large, the amount of oxygen is controlled to be not more than **30** mass ppm.

(**2**) Dispersed substance

It is desirable that the many small dispersed particles be distributed. The reason thereof is that it functions as a precipitation site of sulfur and it is thus required to be small in size and large in number.

Sulfur and titanium form a compound in the form of TiO, $TiO_2$, TiS or Ti-O-S or an aggregate thereof, and the rest of Ti and S is present in the form of solid solution. In the dilute copper alloy material, TiO of not more than **200** nm in size, $TiO_2$ of not more than **1000** nm, TiS of not more than **200** nm and Ti-O-S of not more than **300** nm are distributed in a crystal grain.

Note that, since the size of particle to be formed varies depending on holding time or a cooling status of the molten copper during the casting, it is also necessary to correspondingly determine casting conditions.

(**3**) Casting conditions

As an example of manufacturing a wire rod by the SCR continuous casting and rolling where a working ratio for processing an ingot rod is **90**% (**30** mm) to **99.8**% (5 mm), a method of manufacturing a **8** mm diameter wire rod at a working ratio of **99.3**% is employed.

(a) The molten copper temperature in a melting furnace is not less than **1100**˚C and not more than **1320**˚C. It is determined to be not more than **1320**˚C since there is a tendency that a blow hole is increased, a flaw is generated and a particle size is enlarged when the temperature of the molten copper is high. Although the reason why the temperature is determined to be not less than **1100**˚C is that copper is likely to solidify and the manufacturing is not stable, the molten copper temperature is desirably as low as possible.
(b) The hot rolling temperature is not more than **880**˚C at the initial roll and not less than **550**˚C at the final roll.

Unlike the typical manufacturing conditions of pure copper, since the subject of the invention is to crystallize sulfur in the molten copper and to precipitate the sulfur during the hot rolling, it is preferable to determine the molten copper temperature and the hot rolling temperature to the casting conditions (a) and (b) in order to further decrease a solid solubility limit as an activation energy thereof.

The typical hot rolling temperature is not more than **950**˚C at the initial roll and not less than **600**˚C at the final roll, however, in order to further decrease the solid solubility limit, the temperature in the present embodiment is determined to be not more than **880**˚C at the initial roll and not less than **550**˚C at the final roll.

It is possible to obtain a dilute copper alloy wire or a sheet material such that a wire rod with a diameter of **8** mm has a conductivity of not less than **98**% IACS, not less than **100**% IACS or further not less than **102**% IACS, and a wire material after the cold wire drawing process (e.g., **2.6** mm diameter) has a softening temperature from **130**˚C to **148**˚C.

For the industrial use, not less than **98**% IACS is required for the soft copper wire manufactured from electrolyte copper with industrially usable purity and the softening temperature thereof is not more than **148**˚C in light of the industrial value. When Ti is not added, the softening temperature is from **160** to **165**˚C. Since the softening temperature of Cu (**6**N) is from **127** to **130**˚C, a limit value is determined to be **130**˚C based on the obtained data. This slight difference is caused by inevitable impurities which are not present in Cu (**6**N).

The conductivity of oxygen-free copper is about **101.7**% IACS and that of Cu (**6**N) is about **102.8**% IACS, and therefore, it is desirable to have the conductivity as close to Cu (**6**N) as possible.

A preferable method of stably manufacturing a wire rod to be rolled is that copper as a base material is melted in a shaft furnace and is subsequently cast in a ladle in a reduced-state, i.e., under reductive gas (CO) atmosphere while controlling concentrations of sulfur, Ti and oxygen that are constituent elements of a dilute alloy. Mixture of copper oxide or a particle large in size deteriorates the quality.

Note that, the additive element to be added to pure copper may include at least one of Mg, Zr, Nb, Ca, V, N, Mn, Ti and Cr.

Here, the reason why Ti is selected as an additive element is as follows.

(a) Ti is likely to form a compound by binding to sulfur in the molten copper.
(b) It is possible to process and easy to handle compared to other additive element such as Zr.
(c) It is cheaper than Nb, etc.
(d) It is likely to be precipitated using oxide as a nucleus.

As described above, a practical soft dilute copper alloy material having high productivity and excellent in conductivity, softening temperature and surface quality can be obtained.

In addition, a plating layer may be formed on a surface of the soft dilute copper alloy wire of the present embodiment. It is possible to use a plating layer consisting mainly of, e.g., tin, nickel and silver, or so-called Pb-free plating may be used.

In addition, although an example in which a wire rod is formed by the SCR continuous casting and rolling method and a soft material is formed by the hot rolling has been described in the present embodiment, a twin-roll continuous casting and rolling method or a Properzi continuous casting and rolling method may be used in the invention. Example **1** in the embodiment will be described below.

Example **1**

Table **1** relates to experimental conditions and results.

Table 1

| Experimental material | Oxygen concentration (mass ppm) | S concentration (mass ppm) | Ti concentration (mass ppm) | 2.6 mm diameter semi-softening temperature (°C) | 2.6 mm diameter conductivity of soft material (% IACS) | Evaluation of dispersed particle size | Overall evaluation |
|---|---|---|---|---|---|---|---|
| Comparative Material 1 (small continuous casting machine) | 1 to less than 2 | 5 | 0 | 215 × | 101.7 | ○ | × |
| | 1 to less than 2 | 5 | 7 | 168 × | 101.5 | ○ | × |
| | 1 to less than 2 | 5 | 13 | 160 × | 100.9 | ○ | × |
| | 1 to less than 2 | 5 | 15 | 173 × | 100.5 | ○ | × |
| | 1 to less than 2 | 5 | 18 | 190 × | 99.6 | ○ | × |
| Comparative Material 2 (SCR) | 7 to 8 | 3 | 0 | 164 × | 102.2 | ○ | × |
| | 7 to 8 | 5 | 2 | 157 × | 102.1 | ○ | × |
| Example Material 1 (SCR) | 7 to 8 | 5 | 4 | 148 ○ | 102.1 | ○ | ○ |
| | 7 to 8 | 5 | 10 | 135 ○ | 102.2 | ○ | ○ |
| | 7 to 8 | 5 | 13 | 134 ○ | 102.4 | ○ | ○ |
| | 7 to 8 | 5 | 20 | 130 ○ | 102.2 | ○ | ○ |
| | 7 to 8 | 5 | 25 | 132 ○ | 102.0 | ○ | ○ |
| | 7 to 8 | 5 | 37 | 134 ○ | 101.1 | ○ | ○ |
| | 7 to 8 | 5 | 40 | 135 ○ | 99.6 | ○ | ○ |
| | 7 to 8 | 5 | 55 | 148 ○ | 98.2 | ○ | ○ |
| Comparative Material 3 (SCR) | 7 to 8 | 5 | 60 | 155 × | 97.7 | × Poor surface quality | × |
| Example Material 2 (SCR) | Difficult to control stability at less than 2 | 5 | 13 | 145 ○ | 102.1 | ○ | △ |
| | More than 2 but not more than 3 | 5 | 11 | 133 ○ | 102.2 | ○ | ○ |
| | 3 | 5 | 12 | 133 ○ | 102.2 | ○ | ○ |
| | 30 | 5 | 10 | 134 ○ | 102.0 | ○ | ○ |
| Comparative Material 4 (SCR) | 40 | 5 | 14 | 134 ○ | 101.8 | × Poor surface quality | × |

| Experimental material | Oxygen concentration (mass ppm) | S concentration (mass ppm) | Ti concentration (mass ppm) | **2.6** mm diameter semi-softening temperature (˚C) | **2.6** mm diameter conductivity of soft material (% IACS) | Evaluation of dispersed particle size | Overall evaluation |
|---|---|---|---|---|---|---|---|
| Material **3** Example (SCR) | 7 to 8 | 2 | 4 | 134 ○ | 102.2 | ○ | ○ |
| | 7 to 8 | 10 | 13 | 135 ○ | 102.3 | ○ | ○ |
| | 7 to 8 | 12 | 14 | 136 ○ | 102.2 | ○ | ○ |
| | 7 to 8 | 11 | 19 | 133 ○ | 102.4 | ○ | ○ |
| | 7 to 8 | 12 | 20 | 133 ○ | 102.4 | ○ | ○ |
| Comparative Material 5 | 7 to 8 | 18 | 13 | 162 × | 101.5 | ○ | × |
| Comparative Material 6 (Cu (6N)) | | | | 127 to 130 ○ | 102.8 | None | - |

EP 2 444 978 A2

Firstly, **8** mm diameter copper wires (wire rods) having concentrations of oxygen, sulfur and Ti shown in Table **1** were respectively made at a working ratio of **99.3**% as experimental materials. The **8** mm diameter copper wire has been hot rolled by SCR continuous casting and rolling. Copper molten metal which was melted in a shaft furnace was poured into a ladle under a reductive gas atmosphere, the molten copper poured into the ladle was introduced into a casting pot under the same reductive gas atmosphere, and after Ti was added in the casting pot, the resulting molten copper was introduced through a nozzle into a casting mold formed between a casting wheel and an endless belt, thereby making an ingot rod. The **8** mm diameter copper wire was made by hot rolling the ingot rod. The experimental materials were cold-drawn, and then, the semi-softening temperature and the conductivity of the **2.6** mm diameter copper wire were measured, while the dispersed particle size in the **8** mm diameter copper wire was evaluated.

The oxygen concentration was measured by an oxygen analyzer (Leco oxygen analyzer (Leco: registered trademark)). Each concentration of sulfur and Ti was analyzed by an ICP emission spectrophotometer.

After holding for one hour at each temperature of not more than **400**°C, water quenching and a tensile test were carried out, and the measurement result of the semi-softening temperature of **2.6** mm diameter wire was obtained. It was obtained by using the result of the tensile test at a room temperature and the result of the tensile test of the soft copper wire which was heat-treated in an oil bath at **400**°C for one hour, and the temperature corresponding to a strength value calculated by adding the two tensile strength results in the tensile test and then dividing by two was defined as a semi-softening temperature.

It is desirable that the many small dispersed particles be distributed. The reason thereof is that it functions as a precipitation site of sulfur and it is required to be small in size and large in number. That is, it is judged as "Passed" when not less than **90**% of dispersed particles have a diameter of not more than **500** nm. "Size", as described here, is a size of a compound and means a size of a long diameter of the compound in a shape having long and short diameters. Meanwhile, "particle" indicates TiO, $TiO_2$, TiS and Ti-O-S. In addition, "**90**%" indicates a ratio of the number of such particles to the total number of particles.

In Table **1**, Comparative Material **1** is a copper wire having a diameter of **8** mm which was experimentally formed under Ar atmosphere in the experimental laboratory and in which **0** to **18** mass ppm of Ti was added to the copper molten metal.

In contrast to the semi-softening temperature of **215**°C with no addition of Ti, the semi-softening temperature was lowered to the minimum temperature of **160**°C by adding **13** mass ppm of Ti and was increased by the addition of **15** mass ppm and **18** mass ppm, and the demanded semi-softening temperature of not more than **148**°C was not obtained. Although the industrially demanded conductivity of not less than **98**% IACS was satisfied, the overall evaluation was "×" (Failed).

Next, the oxygen concentration was adjusted be to **7** to **8** mass ppm and a **8** mm diameter copper wire (wire rod) was experimentally formed using the SCR continuous casting and rolling method.

Among the copper wires experimentally formed using the SCR continuous casting and rolling method, Comparative Material **2** has the least Ti concentration (**0** and **2** mass ppm) and the conductivity thereof was not less than **102**% IACS. However, the semi-softening temperature is **164**°C and **157**°C which does not satisfy the required temperature of not more than **148**°C, hence, the overall evaluation is "×".

Experimental materials of Example Material **1** have the substantially constant oxygen and sulfur concentrations (**7** to **8** mass ppm and **5** mass ppm, respectively) and different Ti concentrations (**4** to **55** mass ppm).

The Ti concentration range of **4** to **55** mass ppm is satisfactory because the softening temperature is not more than **148**°C, the conductivity is not less than **98**% IACS or not less than **102**% IACS and the dispersed particle size is not more than **500** μm in not less than **90**% of particles. In addition, the surface of the wire rod is also fine and all materials satisfy the product performances thereof (the overall evaluation is "○" (Passed)).

Here, the copper wire which satisfies the conductivity of not less than **100**% IACS has the Ti concentration of **4** to **37** mass ppm and the copper wire which satisfies not less than **102**% IACS has the Ti concentration of is **4** to **25** mass ppm. The conductivity of **102.4**% IACS which is the maximum value was exhibited when the Ti concentration is **13** mass ppm, and the conductivity at around this concentration was a slightly lower value. This is because, when the Ti is **13** mass ppm, sulfur in copper is trapped as a compound, and thus, the conductivity close to that of high purity copper (**6**N) is exhibited.

Therefore, it is possible to satisfy both of the semi-softening temperature and the conductivity by increasing the oxygen concentration and adding Ti as an additive element.

Comparative Material **3** is an experimental material in which the Ti concentration is increased to **60** mass ppm. Comparative Material **3** satisfies the demanded conductivity, however, the semi-softening temperature is not less than **148**°C, which does not satisfy the product performance. Furthermore, there were many surface flaws on the wire rod, hence, it was difficult to treat as a commercial product. Therefore, the preferable added amount of Ti is less than **60** mass ppm.

Experimental materials of Example Material **2** have a sulfur concentration of **5** mass ppm, a Ti concentration of **13** to **10** mass ppm and various oxygen concentrations to examine the affect of the oxygen concentration.

The experimental materials having largely different oxygen concentrations from more than **2** mass ppm to not more than **30** mass ppm were made. However, since it is difficult to produce and the stable manufacturing is not possible when oxygen is not more than **2** mass ppm, the overall evaluation is ∆ (not good). In addition, it was found that the semi-softening temperature and the conductivity are both satisfied even when the oxygen concentration is increased to **30** mass ppm.

In addition, as shown in Comparative Material **4**, when oxygen was **40** mass ppm, there were many flaws on the surface of the wire rod and it was in a condition which cannot be a commercial product.

Therefore, by adjusting the oxygen concentration so as to fall within a range of more than **2** but not more than **30** mass ppm, it is possible to satisfy all characteristics of the semi-softening temperature, conductivity of not less than **102**% IACS and the dispersed particle size, and in addition, the surface of the wire rod is fine and all materials can satisfy the product performance.

Example Material **3** is an example in which each experimental material has an oxygen concentration relatively close to a Ti concentration and a sulfur concentration varied from **2** to **12** mass ppm. In Example Material **3**, it was not possible to realize an experimental material having the sulfur concentration of less than **2** mass ppm from a viewpoint of raw material. However, it is possible to satisfy both the semi-softening temperature and the conductivity by controlling the concentrations of Ti and sulfur.

Comparative Material **5**, in which the sulfur concentration is **18** mass ppm and Ti concentration is **13** mass ppm, has a high semi-softening temperature of **162**°C and could not satisfy requisite characteristics. In addition, the surface quality of the wire rod is specifically poor, and it was thus difficult to commercialize.

As described above, it was found that all characteristics which are the semi-softening temperature, not less than **102**% IACS of conductivity and the dispersed particle size are satisfied when the sulfur concentration is **2** to **12** mass ppm, the surface of the wire rod is also fine and all product performances are satisfied.

In Comparative Material **6** shown as the result of examining the case of using Cu (**6**N), the semi-softening temperature was **127** to **130**°C, the conductivity was **102.8**% IACS and particles having the dispersed particle size of not more than **500** μm were not observed at all.

Table **2**

| Experimental material | Molten copper temperature (°C) | Oxygen concentration (mass ppm) | S concentration (mass ppm) | Ti concentration (mass ppm) | Hot-rolling temperature (°C) Initial - Final | **2.6** mm diameter semi-softening temperature (°C) | **2.6** mm diameter conductivity of soft material (% IACS) | WR surface quality | Evaluation of dispersed particle size | Overall evaluation |
|---|---|---|---|---|---|---|---|---|---|---|
| Comparative Material **7** | 1350<br>1330 | 15<br>16 | 7<br>6 | 13<br>11 | 950-600<br>950-600 | 148<br>147 | 101.7<br>101.2 | ×<br>× | ×<br>× | ×<br>× |
| Example Material **4** | 1320<br>1300<br>1250<br>1200 | 15<br>16<br>15<br>15 | 5<br>6<br>6<br>6 | 13<br>13<br>14<br>14 | 880-550<br>880-550<br>880-550<br>880-550 | 143<br>141<br>138<br>135 | 102.1<br>102.3<br>102.1<br>102.1 | ○<br>○<br>○<br>○ | ○<br>○<br>○<br>○ | ○<br>○<br>○<br>○ |
| Comparative Material **8** | 1100 | 12 | 5 | 12 | 880-550 | 135 | 102.1 | × | ○ | × |
| Comparative Material **9** | 1300 | 13 | 6 | 13 | 950-600 | 147 | 101.5 | ○ | × | × |
| Comparative Material **10** | 1350 | 14 | 6 | 12 | 880-550 | 149 | 101.5 | × | × | × |

Table **2** shows a molten copper temperature and a rolling temperature as the manufacturing conditions.

Comparative Material **7** is a **8** mm diameter wire rod experimentally formed at the slightly high molten copper temperature of **1330** to **1350**˚C and at the rolling temperature of **950** to **600**˚C.

Although Comparative Material 7 satisfies the semi-softening temperature and the conductivity, there are particles having a dispersed particle size of about **1000** μm and more than **10**% of particles were not less than **500** μm. Therefore, it is judged as inapplicable.

Example Material **4** is a **8** mm diameter wire rod experimentally formed at the molten copper temperature of **1200** to **1320**˚C and the slightly low rolling temperature of **880** to **550**˚C. Example Material **4** was satisfactory in the surface quality of wire and the dispersed particle size, and the overall evaluation was "○".

Comparative Material **8** is a **8** mm diameter wire rod experimentally formed at the molten copper temperature of **1100**˚C and the slightly low rolling temperature of **880** to **550**˚C. Comparative Material **8** was not suitable as a commercial product since there were many surface flaws on the wire rod due to the low molten copper temperature. This is because the flaws are likely to be generated at the time of rolling since the molten copper temperature is low.

Comparative Material **9** is a **8** mm diameter wire rod experimentally formed at the molten copper temperature of **1300**˚C and the slightly high rolling temperature of **950** to **600**˚C. The wire rod in Comparative Material **9** has satisfactory surface quality since the hot rolling temperature is high, however, the large dispersed particles are present and the overall evaluation is "×".

Comparative Material **10** is a **8** mm diameter wire rod experimentally formed at the molten copper temperature of **1350**˚C and the slightly low rolling temperature of **880** to **550**˚C. In Comparative Material **10**, the large dispersed particles are present since the molten copper temperature is high, and the overall evaluation is "×".

Softening characteristics of Soft dilute copper alloy wire

Comparative Material **11** using an oxygen-free copper wire and Example Material **5** using a soft dilute copper alloy wire formed of low-oxygen copper including **13** mass ppm of Ti were used as samples and were annealed at different annealing temperatures for **1** hour, and Vickers hardness (Hv) was examined and is shown in Table **3**.

The alloy composition of Example Material **5** is the same as that described in Example Material **1** of Table **1**. In addition, the sample used here has a diameter of **2.6** mm. According to Table **3**, Vickers hardness (Hv) of Comparative Material **11** is at the equivalent level to that of Example Material **5** at the annealing temperature of **400**˚C, as well as at the annealing temperature of **600**˚C. This shows that the soft dilute copper alloy wire in Example **1** has sufficient softening characteristics and is especially excellent in softening characteristics at the annealing temperature of more than **400**˚C, from comparison to an oxygen-free copper wire.

Table 3

|  | **20**˚C | **400**˚C | **600**˚C |
|---|---|---|---|
| Example Material **5** | 120 | 52 | 48 |
| Comparative Material **11** | 124 | 53 | 56 |
| (Unit: Hv) | | | |

Examination of Proof stress and Bending life of Soft dilute copper alloy wire

Comparative Material **12** using an oxygen-free copper wire and Example Material **6** using a soft dilute copper alloy wire formed of low-oxygen copper including **13** mass ppm of Ti were used as samples and were annealed at different annealing temperatures for **1** hour, and variation in a **0.2**% proof stress value was examined and is shown in Table **4**. The sample used here has a diameter of **2.6** mm.

Table **4** shows that the **0.2**% proof stress value of Comparative Material **12** and that of Example Material **6** are at the equivalent level at the annealing temperature of **400**˚C, and are nearly the same at the annealing temperature of **600**˚C.

Table 4

|  | **20**˚C | **250**˚C | **400**˚C | **600**˚C | **700**˚C |
|---|---|---|---|---|---|
| Example Material **6** | 421 | 80 | 58 | 35 | 25 |

(continued)

| | 20°C | 250°C | 400°C | 600°C | 700°C |
|---|---|---|---|---|---|
| Comparative Material 12 | 412 | 73 | 53 | 32 | 24 |
| (Unit: Hv) | | | | | |

T

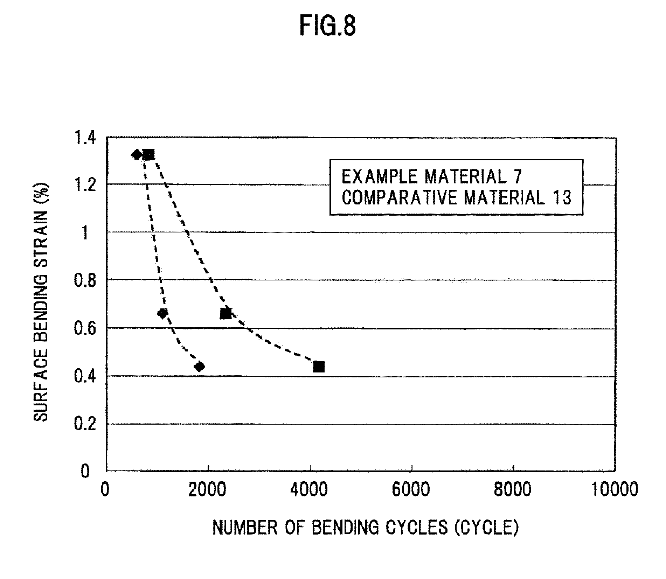

The soft dilute copper alloy wire in Example 1 is required to have a long bending life. **FIG.8** shows the measurement results of the bending life of Comparative Material **13** using an oxygen-free copper wire and Example Material 7 using a soft dilute copper alloy wire formed of low-oxygen copper with addition of Ti. Each sample used here is a **0.26** mm diameter wire rod annealed at the annealing temperature of **400**°C for **1** hour, where Comparative Material **13** has the same element composition as Comparative Material **11** and Example Material **7** has the same element composition as Example Material **5.**

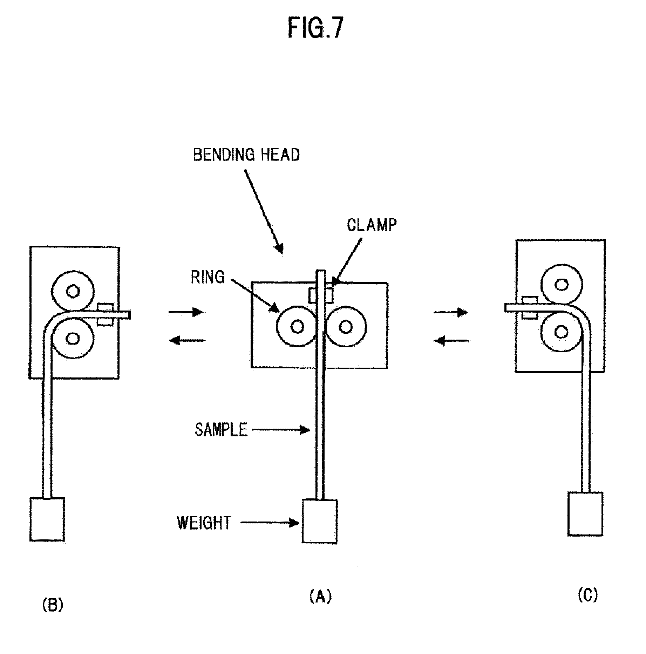

**FIG.7** is a schematic view showing a bending fatigue test. As a method of measuring a bending life, a bending fatigue test was conducted. In the bending fatigue test, a load is applied to a sample to impart tension and compression strain to the surface thereof by cyclic bending. The bending fatigue test was conducted using a bending tester shown in **FIG.7**. The sample is placed between bending jigs (which are referred to as "ring" in the figure) as shown in (A) and is bent by a **90**° rotation of the jigs as shown in (B) while the load is still applied. This operation applies a compressive strain to a surface of the wire rod in contact with the bending jig and a tensile strain to an opposite surface. After that, it returns to a state (A) again. Then, the sample is bent by a **90**° rotation in a direction opposite to the direction shown in (B). This also applies a compressive strain to the surface of the wire rod in contact with the bending jig and a tensile strain to the opposite surface, and it becomes a state (C). Then, the sample returns from the state (C) to the initial state (A). One bending fatigue cycle consisting of (A)-(B)-(A)-(C)-(A) requires **4** seconds. The surface bending strain can be derived by the following formula (**1**).

$$\text{Surface bending strain (\%)} = r/(R+r) \times \mathbf{100}\ (\%)\ \dots\ (\mathbf{1})$$

R: bending radius of wire
r: radius of wire

**FIG.8** is a graph showing bending lives of Comparative Material **13** using an oxygen-free copper wire and Example Material 7 using a soft dilute copper alloy wire in which Ti is added to low-oxygen copper, which are measured after annealing treatment at **400**°C for **1** hour.

According to the test data shown in **FIG.8**, the bending life of Example Material 7 in Example **1** is longer than Comparative Material **13.**

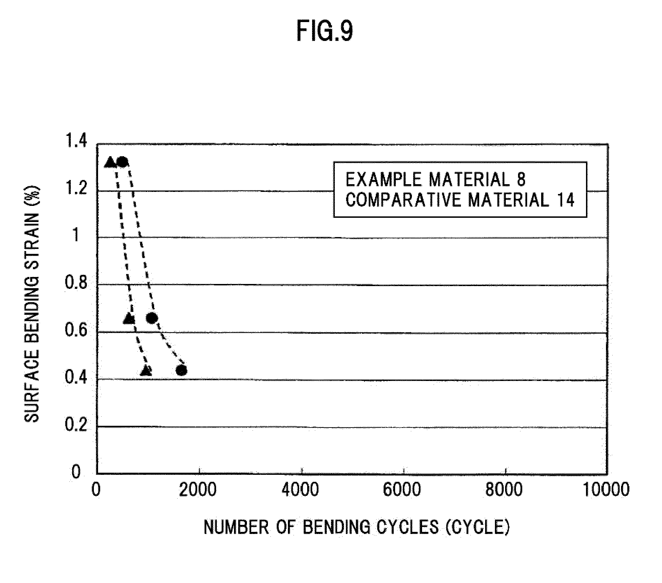

**FIG.9** is a graph showing bending lives of Comparative Material **14** using an oxygen-free copper wire and Example Material **8** using a soft dilute copper alloy wire in which Ti is added to low-oxygen copper, which are measured after annealing treatment at **600**°C for **1** hour.

**FIG.9** shows the measurement results of the bending lives of Comparative Material **14** using an oxygen-free copper wire and Example Material **8** using a soft dilute copper alloy wire formed of low-oxygen copper with addition of Ti. Each sample used here is a **0.26** mm diameter wire rod annealed at the annealing temperature of **600**°C for **1** hour, where Comparative Material **14** has the same element composition as Comparative Material **11** and Example Material **8** has the same element composition as Example Material **5.** The bending life was measured under the same conditions as the measuring method shown in **FIG.8**. Also in this case, the bending life of Example Material **8** in Example **1** is longer than Comparative Material **14.** It is understood that the cause of this result is that Example Materials 7 and **8** exhibit a greater **0.2**% proof stress value than Comparative Materials **13** and **14** under any annealing conditions.

Examination of crystal structure of soft dilute copper alloy wire

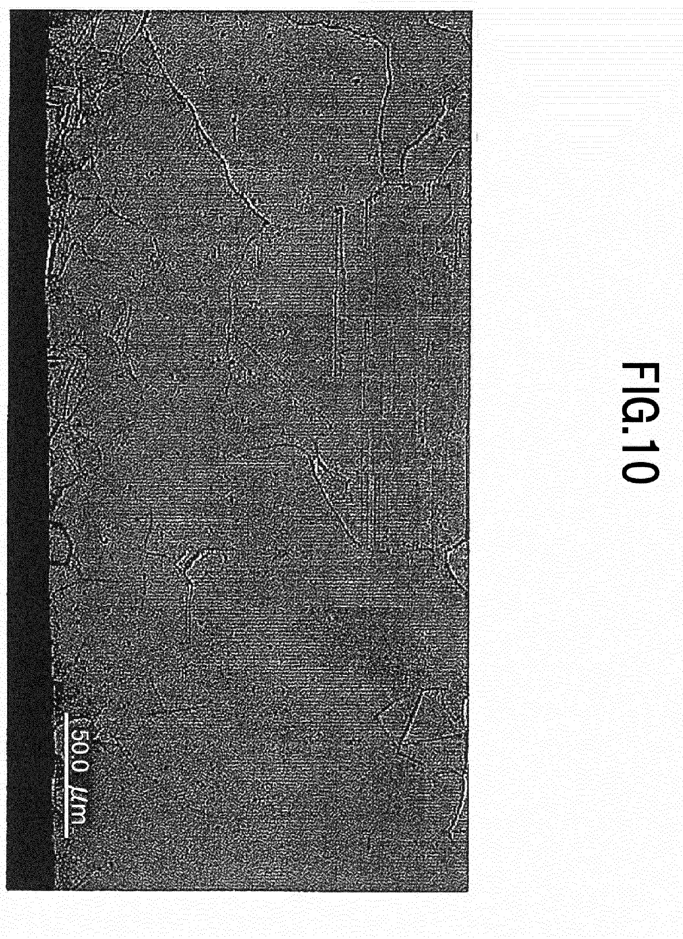

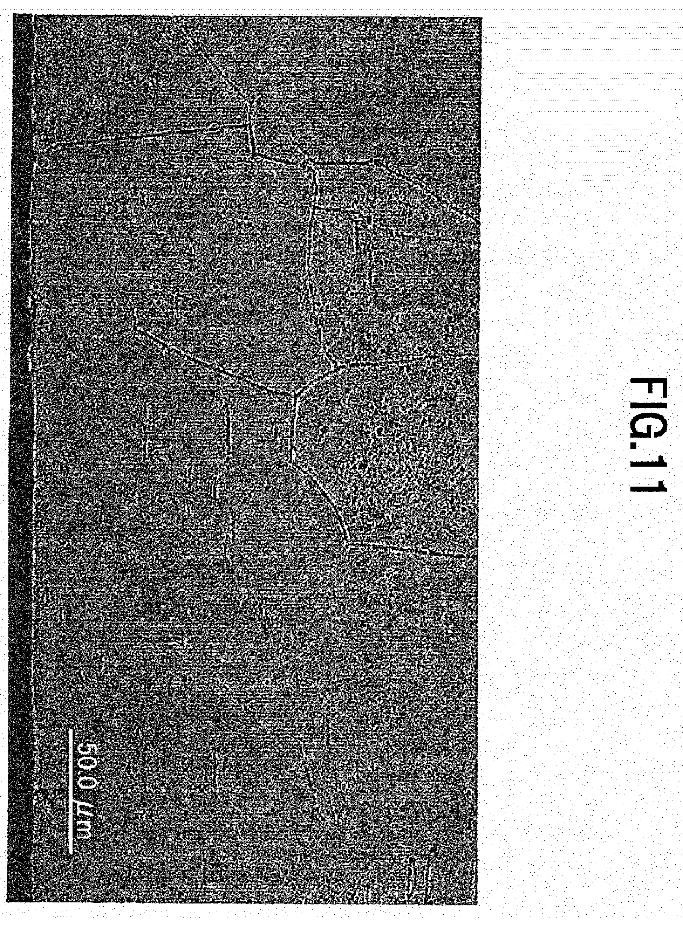

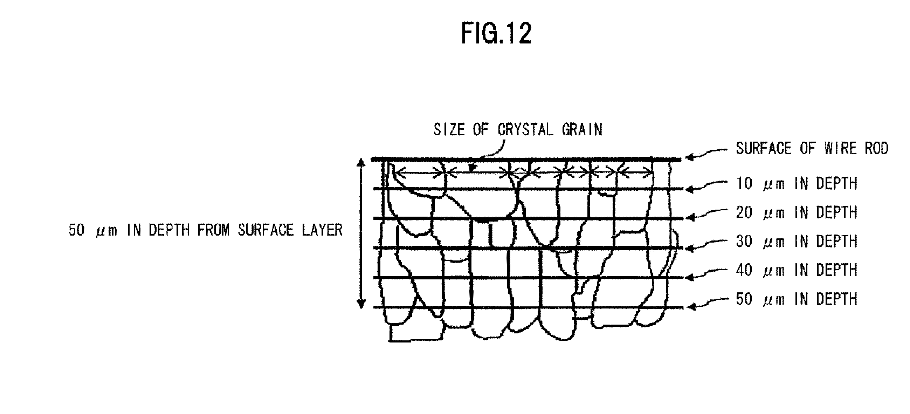

Meanwhile, **FIG.10** is a photograph showing a cross section structure across-the-width of Example Material **8. FIG.11** is a photograph showing a cross section structure across-the-width of Comparative Material **14. FIG.12** is an explanatory diagram illustrating a measuring method of an average crystal grain size in a surface layer of a sample. **FIG.11** shows a crystal structure of Comparative Material **14** and **FIG.10** shows a crystal structure of Example Material **8.**

As shown in **FIG.11**, it is understood that crystal grains having an equal size all around are uniformly aligned from the surface to the middle portion in the crystal structure of Comparative Material **14.** In contrast, the size of crystal grain in the crystal structure of Example Material **8** is uneven as a whole as shown in **FIG.10**, and notably, a crystal grain size in a thin layer formed on the sample near a surface thereof in a cross-sectional direction is extremely smaller than that of inner side.

The inventors consider that a fine crystal grain layer appeared as a surface layer, which is not formed in Comparative Material **14**, contributes to improve bending characteristics of Example Material **8.** In general, it is understood that uniformly coarsened crystal grains are formed by recrystallization as is in Comparative Material **14** if annealing treatment is carried out at an annealing temperature of **600**°C for **1** hour. However, a fine crystal grain layer remains as a surface layer in Example **1** even after the annealing treatment at the annealing temperature of **600**°C for **1** hour, hence, a soft dilute copper alloy material with satisfactory bending characteristics is obtained even though it is a soft copper material.

Then, average crystal grain sizes in the surface layers of the samples of Example Material **8** and Comparative Material **14** were measured based on the cross-sectional images of the crystal structures shown in **FIGS.10** and **11**. For measuring an average crystal grain size in the surface layer, the crystal grain size was each measured within **1** mm in length from a surface of a widthwise cross section with **2.6** mm diameter up to a depth of **50** $\mu$m at intervals of **10** $\mu$m in a depth direction as shown in **FIG.12**, and an average value of the actual measured values was defined as an average crystal grain size in the surface layer.

As a result of the measurement, the average crystal grain size in the surface layer of Comparative Material **14** was **50** $\mu$m, and is largely different from that of Example Material **8** which was **10** $\mu$m. It is believed that a fine average crystal grain size in the surface layer suppresses development of cracks caused by the bending fatigue test, which extends the bending fatigue life (cracks are developed along a crystal boundary when the crystal grain size is large, on the other hand, the development of cracks is suppressed when the crystal grain size is small since a developing direction of cracks is changed). It is considered that this causes a large difference in the bending characteristics between Comparative Materials and Example Materials as described above.

Meanwhile, average crystal grain sizes in the surface layers of Example Material **6** and Comparative Material **12** which have a diameter of **2.6** mm were obtained by measuring crystal grain sizes within **10** mm in length from the surface of a widthwise cross section with **2.6** mm diameter up to a depth of **50** $\mu$m in a depth direction.

As a result of the measurement, the average crystal grain size in the surface layer of Comparative Material **12** was **100** $\mu$m and that of Example Material **6** was **20** $\mu$m.

Therefore, the upper limit of the average crystal grain size in the surface layer of the conductor in the present embodiment is preferably not more than **20** $\mu$m, and considering a limit value for production, it is preferably not less than **5** $\mu$m. Example **2** in which the conductor of the present embodiment is used for a solar cell conductor will be described below.

Example **2**

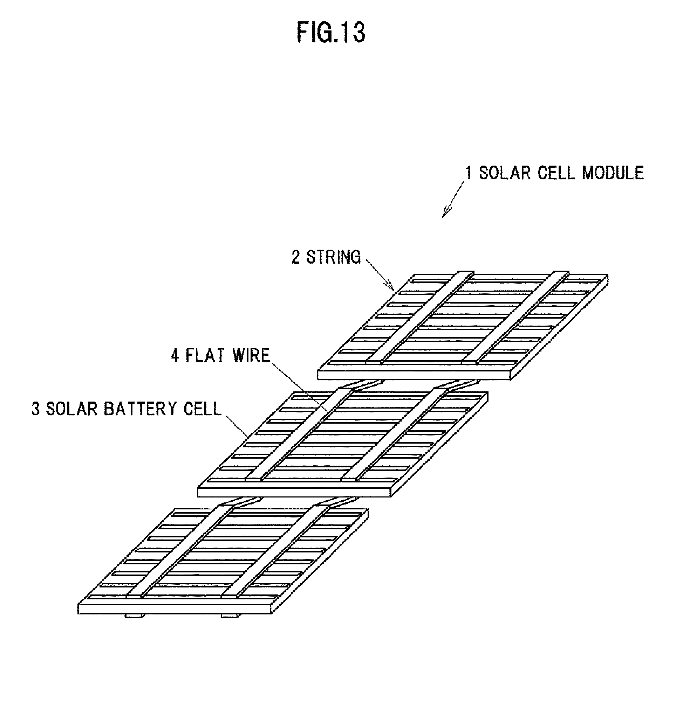

**FIG.13** is a schematic view showing a solar cell module using a solar cell conductor in Example **2**. In Example **2**, a conductor manufactured by the manufacturing method in the present embodiment is used as a solar cell conductor.

Schematic structure of solar cell module **1**

As shown in **FIG.13**, the solar cell module **1** is schematically configured such that plural strings **2** are electrically connected by a flat wire **4** as a solar cell conductor.

For example, a negative collecting electrode of a solar battery cell **3** made of crystalline silicon is connected to a positive collecting electrode of an adjacent solar battery cell **3** by the flat wire **4**.

The flat wire **4** is formed by, e.g., coating an outer periphery of a copper conductor processed to have a substantially rectangular cross section with a solder material. The flat wire **4** is bonded to the negative collecting electrode and the positive collecting electrode of the solar battery cell **3** by using, e.g., the solder material coating the periphery.

As an example of the cross-sectional dimension of a conductor constituting the flat wire **4**, a width is about **1** to **3** mm and a thickness is about **0.15** to **0.3** mm. The flat wire **4** is bonded to the negative collecting electrode and the positive collecting electrode at a solidus temperature of the solder material.

For example, one flat wire **4** is formed to have substantially the same width as one of the solar battery cells **3** provided in parallel in order to modularize by connecting the solar battery cells **3** in series. The flat wire **4** is connected to a front surface of one solar battery cell **3**, is bent at a position between silicon cells, and is connected to a back surface of another solar battery cell **3**.

Samples **1** to **3** of Example **2**

Sn is plated on a wire which is formed of a raw material shown in the third row of Example **1** in Table **1**, a flat conductor obtained by rolling the Sn-plated wire so as to have a width of **2.0** mm and a thickness of **0.16** mm is formed into a conductor by roll forming and the conductor is heat-treated under various conditions, thereby respectively forming the samples **1** to **3** in Example **2**.

The sample **1** is made by heat-treating at **850**°C for **40** minutes. The sample **2** is made by heat-treating at **750**°C for **40** minutes. The sample **3** is made by heat-treating at **650**°C for **60** minutes.

In the samples **1** to **3**, a solder plating film is provided by coating the periphery of the heat-treated conductor with Cu-based Pb-free solder having **3**% of tin (Sn) and **0.5**% of silver (Ag), and then, a **0.2%** proof stress value of Cu forming the solder-coated flat copper wire and that of Cu with solder-coating were measured.

A manufacturing method of the samples **1** to **3** is such that a **8** mm diameter wire rod is made at a molten copper temperature of **1320**°C and a rolling temperature of **880** to **550**°C, and is then drawn to obtain a **32** μm-diameter wire.

Samples **4** to **6** of Comparative Example

The samples **4** to **6** of Comparative Example are made under the same conditions as Example **2**, except that oxygen-free copper (OFC) is used.

Evaluation

The fatigue life of the conductor (copper foil) was evaluated by a bending life test. The bending life test was conducted on a copper foil sample which has the same heat history as the wiring parts for solar cell. A silver foil sample was **10** mm in width and about **500** mm in length.

The copper foil sample was placed in the bending tester shown in **FIG.7**, a weight was attached thereto and the bending jig was repeatedly rotated **90**° to right and left, thereby conducting the bending life test.

The movement of the jig starting from the initial position, a **90**° right rotation, a **90**° left rotation (back to the initial position), a **90**° left rotation and to a **90**° right rotation (back to the initial position) is defined as one cycle. The number of cycles when the copper foil sample is broken is determined as the bending life, and the test was carried out with a target to obtain the bending life of not less than **20,000** cycles.

The bending radius R of the bending jig was determined so that bending strain shown by the following formula (**2**) is **0.25**%.

$$\text{Bending strain} = \{d/(2R+d)\} \times \mathbf{100}\ (\%) \dots \mathbf{(2)}$$

Here, "d" is a thickness of the copper foil sample.

For the evaluation of the bending test, a circle shown in Tables **5** and **6** indicates that the bending life of the sample in Example **2** is longer than the corresponding sample in Comparative Example, where each sample in Comparative Example is considered as a standard. A triangle indicates the bending life equivalent to that of Comparative Example.

Meanwhile, a circle shown in the evaluation of crack generation on a silicon substrate of a solar cell indicates no crack generation. Following Table **5** shows an evaluation result of Example **2** and Table **6** shows an evaluation result of Comparative Example.

Table **5**

| (Invention Examples) | | | | | | | |
|---|---|---|---|---|---|---|---|
| | Heat treatment conditions | | 0.2% proof stress (MPa) | | Elongation of Cu (%) | Bending life | Crack generation on cell |
| Number of Sample | Temperature (°C) | Time (min) | Cu | Cu with Solder coating | | | |
| 1 | 850 | 40 | 29 | 47 | 25 | ○ | ○ |
| 2 | 750 | 40 | 31 | 51 | 26 | ○ | ○ |
| 3 | 650 | 60 | 35 | 55 | 28 | ○ | ○ |

Table 6

| (Comparative Examples) | | | | | | | |
|---|---|---|---|---|---|---|---|
| | Heat treatment conditions | | **0.2%** proof stress (MPa) | | Elongation of Cu (%) | Bending life | Crack generation on cell |
| Number of Sample | Temperature (˚C) | Time (min) | Cu | Cu with Solder coating | | | |
| **4** | 850 | 40 | 1735 | 47 | 7 | Δ | ○ |
| **5** | 750 | 40 | 20 | 40 | 10 | Δ | ○ |
| **6** | 650 | 60 | 30 | 50 | 20 | Δ | ○ |

As shown in Tables **5** and **6**, the **0.2**% proof stress value in Example **2** without solder coating was **29** MPa in the sample **1**, **31** MPa in the sample **2** and **35** MPa in the sample **3**. Meanwhile, it was **47** MPa in the sample **1**, **51** MPa in the sample **2** and **55** MPa in the sample **3** in case that the solder coating is present.

On the other hand, the **0.2**% proof stress value in Comparative Example without solder coating was **17** MPa in the sample **4**, **20** MPa in the sample **5** and **30** MPa in the sample **6.** Meanwhile, it was **35** MPa in the sample **4**, **40** MPa in the sample **5** and **50** MPa in the sample **6** in case that the solder coating is present. Therefore, the samples in Example **2** exhibit the higher **0.2**% proof stress value than the samples in Comparative Example under the same conditions.

As shown in Tables **5** an **6**, cracks were not generated on the silicon substrate either in the samples **1** to **3** in Example **2** and the samples **4** to **6** in Comparative Example. However, the number of bending cycles is larger in the samples **1** to **3** in Example **2** than in the samples **4** to **6** in Comparative Example which are heat-treated under respectively the same conditions as the samples **1** to **3**.

Here, as for each sample in Example **2**, the elongation of Cu was **25**% in the sample **1**, **26**% in the sample **2** and **28**% in the sample **3**. Meanwhile, as for each sample in Comparative Example, the elongation of Cu was **7**% in the sample **4**, **10**% in the sample **5** and **20**% in the sample **6**.

That is, each sample in Example **2** is a material with enhanced elongation in a lower proof stress range than the oxygen-free copper (OFC) sample in Comparative Example, and thus has better bending life than the sample in Comparative Example. Therefore, the sample in Example **2**, which has a **0.2**% proof stress value of not more than **55** MPa as well as an elongation percentage of not less than **25**% under heat treatment conditions at a low temperature of **650**˚C, is better than the sample in Comparative Example.

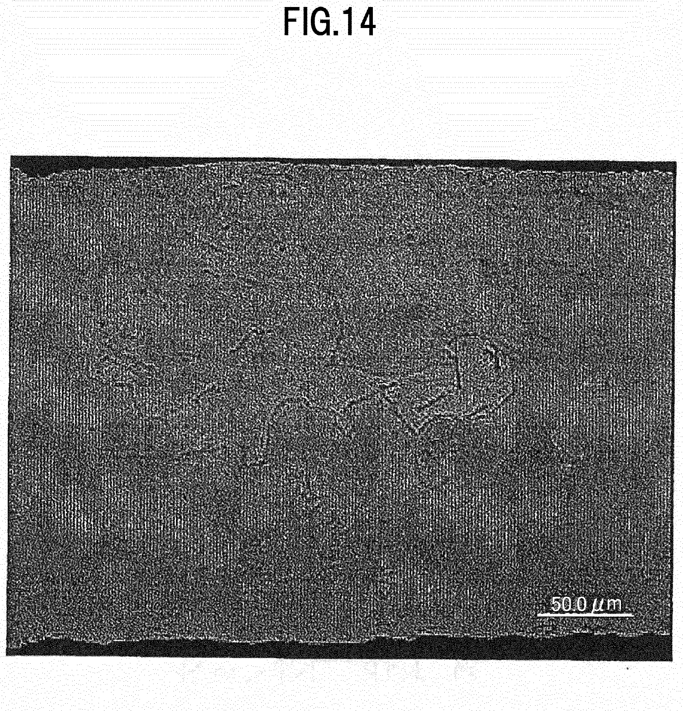

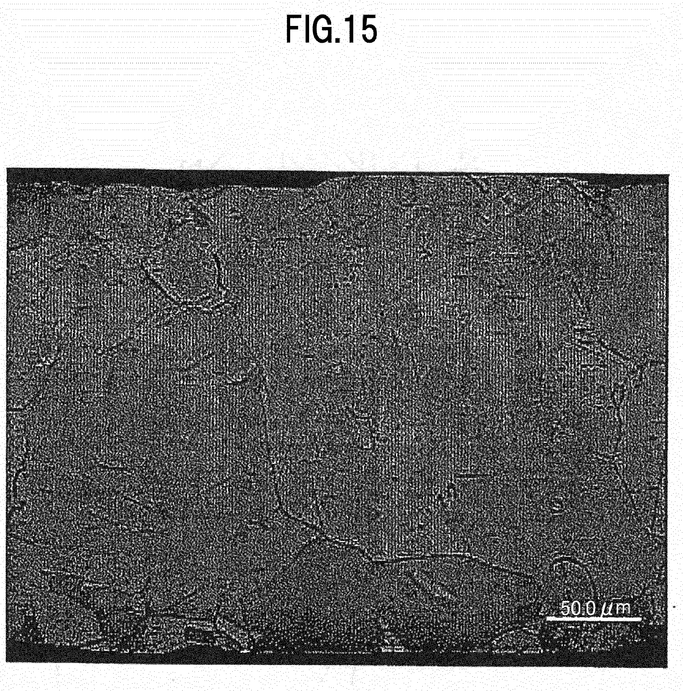

**FIG.14** is a photograph showing a cross section structure across-the-width of Example Material **9** and **FIG.15** is a photograph showing a cross section structure across-the-width of Comparative Material **15**. **FIG.14** shows a crystal structure of Example Material **9** and **FIG.15** shows a crystal structure of Comparative Material **15**.

Example Material **9** is a **2.6** mm diameter wire rod formed of a soft material having the highest conductivity shown in the third row of Example **1** in Table **1**. Example Material **9** is made through annealing treatment at an annealing temperature of **400**˚C for **1** hour.

Comparative Material **15** is a **2.6** mm diameter wire rod formed of oxygen-free copper (OFC). Comparative Material **15** is made through annealing treatment at an annealing temperature of **400**˚C for **1** hour.

As shown in **FIGS.14** and **15**, it is understood that crystal grains having an equal size all around are uniformly aligned from the surface to the middle portion in the crystal structure of Comparative Material **15**. In contrast, the size of crystal grain in the crystal structure of Example Material **9** is uneven as a whole, and notably, a crystal grain size in a thin layer formed on the sample near a surface thereof in a cross-sectional direction is extremely smaller than that of inner side.

In Example Material **9**, sulfur (S) in copper of a conductor which is processed to have a diameter of, e.g., **2.6** mm or **0.26** mm is trapped in the form of Ti-S or Ti-O-S. In addition, oxygen (O) included in copper is present in the form of $Ti_xO_y$, e.g., $TiO_2$, and is precipitated in a crystal grain or at crystal grain boundary.

Therefore, in Example Material **9**, recrystallization is likely to proceed and a crystal grows with a large crystal grain boundary at the time of recrystallization of the crystal structure by annealing the copper. Accordingly, when passing an electric current through Example Material **9**, electron flow is less disturbed as compared to Comparative Material **15**, hence, electrical resistance decreases. Therefore, the conductivity (%IACS) of Example Material **9** is greater than that of Comparative Material **15**.

As a result, a solar cell conductor using Example Material **9** is soft and can have an improved conductivity and improved bending characteristics. A conventional conductor requires high temperature annealing treatment in order to re-crystallize as small crystal structure as Example Material **9**. In addition, there is a problem that the conventional conductor is softened at the time of recrystallization and the bending characteristics are degraded. Example Material **9** described above has large crystals and is soft due to recrystallization without twining at the time of annealing, however, it has a feature that the bending characteristics are not degraded since fine crystals remain in the surface layer.

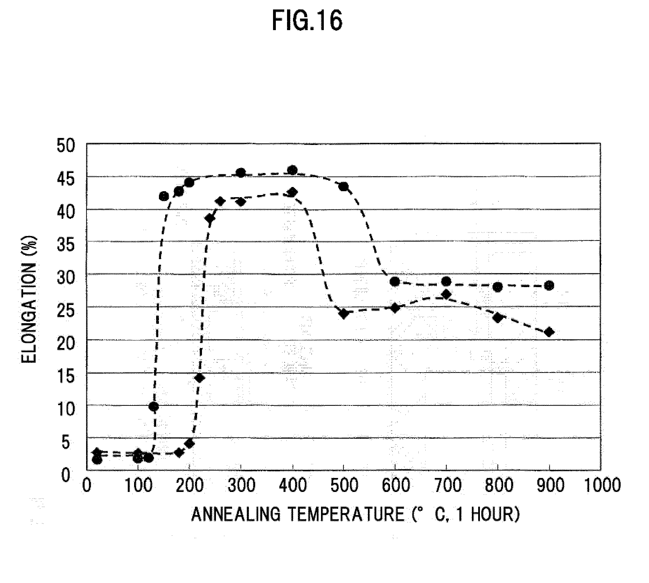

**FIG.16** is a graph showing a relation between an annealing temperature (˚C, **1** hour) and an elongation (%). This graph shows a relation between annealing conditions and elongation of a raw material used for the sample in Example **2** and the sample (ODC) in Comparative Example which have a diameter of **2.6** mm. In **FIG.16**, a square point indicates the sample in Comparative Example and a circle point indicates the sample in Example **2.**

In Example **2**, the same conductor as Example Material **7** is used. As shown in **FIG.16**, it is understood that the elongation (%) in Example **2** is greater than that in Comparative Example (OFC) at a temperature of not less than **600**˚C which is an annealing temperature range of Example **2**, hence, Example Material **7** is better than the sample in Comparative Example.

As described above, a solar cell conductor which includes an additive element and inevitable impurities as a balance has better flexibility than high purity copper (**6**N) while having a conductivity equivalent to purity copper (**6**N) , and the manufacturing cost is less than purity copper (**6**N). That is, in the solar cell conductor, a crystal grain size on the surface is kept to be small such that an average crystal grain size in the surface layer from the conductor surface up to a depth of **50** $\mu$m is not more than **20** $\mu$m even under the heat treatment at **650**˚C for **1** hour, and a material having better elongation characteristics than the oxygen-free copper (OFC) sample is used, hence, flex resistance is excellent even in a low proof stress range.

In contrast, it is shown that a layer of a crystal having a fine crystal grain size is not formed on a surface of the sample (OFC) in Comparative Example. Meanwhile, although the elongation characteristics tend to degrade with increasing a temperature of the heat treatment conditions in both Example **2** and Comparative Example (OFC), a decrease in elongation in Example **2** is smaller than in Comparative Example (OFC). Accordingly, Example **2** is provided with a property to keep elongation high even in a high-temperature range of the heat treatment conditions, and it is possible to address the problem of much lower proof stress of the solar cell conductor and the problem of cracks on a cell in accordance with further thinning of the solar battery cell. Therefore, the flat wire **4** in Example **2** suppresses warpage of the solar battery cell and is excellent in the bending fatigue characteristics.

Although the embodiment of the invention and modifications thereof have been described, the invention according to claims is not to be limited to the above-mentioned embodiment and modifications. Further, please note that not all combinations of the features described in the embodiment and modifications are not necessary to solve the problem of the invention.

## Claims

1. A solar cell conductor, comprising:

   an additive element comprising at least one of Mg, Zr, Nb, Ca, V, Ni, Mn, Ti and Cr;
   more than **2** mass ppm of oxygen;
   pure copper comprising an inevitable impurity;
   a **0.2**% proof stress value of not more than **55** MPa; and
   an elongation percentage of not less than **25**%.

2. The solar cell conductor according to claim **1**, wherein the additive element comprises **4** to **25** mass ppm of Ti and **3** to **12** mass ppm of sulfur.

3. A method of manufacturing a solar cell conductor, comprising:

   making a molten metal by melting a dilute copper alloy material at a copper melting temperature of not less than **1100**˚C and not more than **1320**˚C, the dilute copper alloy material comprising more than **2** mass ppm of oxygen and an additive element;
   forming a wire rod from the molten metal;
   hot-rolling the wire rod at a temperature of not more than **880**˚C and not less than **550**˚C; and
   forming a conductor by drawing the hot-rolled wire rod.

4. The method according to claim **3**, wherein the additive element comprising at least one of Mg, Zr, Nb, Ca, V, Ni, Mn, Ti and Cr.

5. The method according to claim **3** or **4**, wherein the additive element comprises **4** to **25** mass ppm of Ti and **3** to **12** mass ppm of sulfur.

FIG.1

FIG.2

EP 2 444 978 A2

FIG.3

# FIG.4

EP 2 444 978 A2

FIG.5

FIG.6

# FIG.7

BENDING HEAD

CLAMP

RING

SAMPLE

WEIGHT

(B)

(A)

(C)

# FIG.8

FIG.9

FIG.10

FIG.11

## FIG.12

SIZE OF CRYSTAL GRAIN

SURFACE OF WIRE ROD

10 $\mu$m IN DEPTH

20 $\mu$m IN DEPTH

30 $\mu$m IN DEPTH

40 $\mu$m IN DEPTH

50 $\mu$m IN DEPTH

50 $\mu$m IN DEPTH FROM SURFACE LAYER

EP 2 444 978 A2

# FIG.13

1 SOLAR CELL MODULE

2 STRING

4 FLAT WIRE

3 SOLAR BATTERY CELL

# FIG.14

50.0 μm

# FIG.15

# FIG.16

## REFERENCES CITED IN THE DESCRIPTION

**Patent documents cited in the description**

- WO 2005114751 A